# EUROPÄISCHE PATENTSCHRIFT

(11) **EP 1 202 333 B1**
(45) Veröffentlichungstag und Bekanntmachung des Hinweises auf die Patenterteilung: **08.03.2006**
(21) Anmeldenummer: 01122386.4
(22) Anmeldetag: 19.09.2001
(51) Int. Cl.: H01L 21/28, H01L 21/02, H01L 21/8246, H01L 27/115

(54) **Speicherkondensator und zugehörige Kontaktierungsstruktur sowie Verfahren zu deren Herstellung**
Storage capacitor, contact structure and method of manufacturing
Condensateur de stockage, structures de contact et procédé de fabrication

(30) Priorität: 26.10.2000 DE 10053170
(43) Veröffentlichungstag der Anmeldung: 02.05.2002
(73) Patentinhaber: Infineon Technologies AG, 81669 München (DE)
(72) Erfinder: Sitaram, Arkalgud, Fishkill, NY 12524 (US); Dehm, Christine, 90403 Nürnberg (DE); Mazuré-Espejo, Carlos, 38330 St. Nazaire les Eymes (FR)
(74) Vertreter: Graf Lambsdorff, Matthias

(56) Entgegenhaltungen:
- EP-A- 0 991 117
- WO-A-00/14796
- US-A- 5 828 092
- CHA SEON YONG ET AL: "Deoxidization of iridium oxide thin film" JPN J APPL PHYS PART 2 LETTER;JAPANESE JOURNAL OF APPLIED PHYSICS, PART 2: LETTERS 1999 JJAP, TOKYO, JAPAN, Bd. 38, Nr. 10 A, 1999, Seiten L1128-L1130, XP002270143
- SHAOHONG KUAH ET AL: "Interaction of Ir and IrO/sub 2/ thin films with polysilicon, W and WSi/sub x/" NINTH INTERNATIONAL SYMPOSIUM ON INTEGRATED FERROELECTRICS, SANTA FE, NM, USA, 3-5 MARCH 1997, Bd. 17, Nr. 1-4, Seiten 479-488, XP008027602 Integrated Ferroelectrics, 1997, Gordon & Breach, Netherlands ISSN: 1058-4587

## Beschreibung

Die Erfindung betrifft generell das Gebiet von Speicherkondensatoren wie sie bei höchstintegrierten Speicherbauelementen wie DRAM-Halbleiter-Speicherbauelementen eingesetzt werden. Insbesondere bezieht sich die Erfindung dabei auf solche Speicherbauelemente, bei denen der Speicherkondensator als ein sogenannter Stapelkondensator "(stacked capacitor") ausgebildet ist. Bei einem derartigen Speicherbauelement sind der Speicherkondensator und der ihn ansteuernde Auswahltransistor im wesentlichen übereinander angeordnet und durch eine Isolationsschicht voneinander getrennt, in der ein Durchgangskontakt zur elektrischen Kontaktierung zwischen dem Auswahltransistor und dem Speicherkondensator geformt ist. Die Erfindung bezieht sich dabei insbesondere, jedoch nicht ausschließlich auf ferroelektrische oder paraelektrische Speicherkondensatoren. Außerdem bezieht sich die Erfindung auf Verfahren zur Herstellung von Speicherbauelementen und den in ihnen enthaltenen Speicherkondensatoren und zugehörigen Kontaktstrukturen

Die in der Mikroelektronik hergestellten dynamischen Halbleiterspeicher-Bauelemente (DRAMs) bestehen im wesentlichen aus einem Auswahl- oder Schalttransistor und einem Speicherkondensator, in welchem zwischen zwei Kondensatorplatten ein dielektrisches Material eingefügt ist. Als Dielektrikum werden üblicherweise zumeist Oxid- oder Nitridschichten verwendet, die eine Dielektrizitätskonstante von maximal etwa 8 aufweisen. Zur Verkleinerung des Speicherkondensators sowie zur Herstellung von nicht-flüchtigen Speichern werden "neuartige" Kondensatormaterialien, wie beispielsweise ferroelektrische oder paraelektrische Materialien mit deutlich höheren Dielektrizitätskonstanten, benötigt. Ein paar dieser Materialien sind in der Publikation "Neue Dielektrika für Gbit-Speicherchips" von W. Hönlein, Phys. Bl. 55 (1999), genannt. Zur Herstellung von ferroelektrischen Kondensatoren für Anwendungen in derartigen nicht-flüchtigen Halbleiterspeicher-Bauelementen hoher Integrationsdichte können z.B. ferroelektrische Materialien, wie SrBi₂ (Ta, Nb)₂O₉ (SBT oder SBTN), Pb (Zr, Ti)O₃ (PZT), oder Bi₄Ti₃O₁₂ (BTO) als Dielektrikum zwischen den Kondensatorplatten eingesetzt werden. Es kann aber auch ein paraelektrisches Material, wie beispielsweise (BaSr) TiO₃ (BST), zum Einsatz kommen. Wenn im folgenden von ferroelektrischen Materialien die Rede sein wird, so sollen hiervon gleichermaßen paraelektrische Materialien umfaßt sein.

Die Verwendung ferroelektrischer Materialien für Speicherkondensatoren stellt die Halbleiterprozeßtechnologie vor neue Herausforderungen. Zunächst lassen sich diese neuartigen Materialien nämlich nicht mehr mit dem traditionellen Elektrodenmaterial Polysilizium kombinieren. Der Grund hierfür liegt darin, daß nach dem Abscheiden des ferroelektrischen Materials dieses in einer sauerstoffhaltigen Atmosphäre bei Temperaturen von etwa 550 - 800°C gegebenenfalls mehrfach getempert ("konditioniert") werden muß. Zur Vermeidung von unerwünschten chemischen Reaktionen des ferroelektrischen Materials mit den Elektroden müssen ausreichend temperaturstabile und inerte Elektrodenmaterialien, wie beispielsweise Platinmetalle, d.h. Pt, Pd, Ir, Rh, Ru oder Os, deren leitfähige Oxide (z.B. RuO₂) oder andere leitfähige Oxide wie LaSrCoOx oder SrRuO₃ eingesetzt werden.

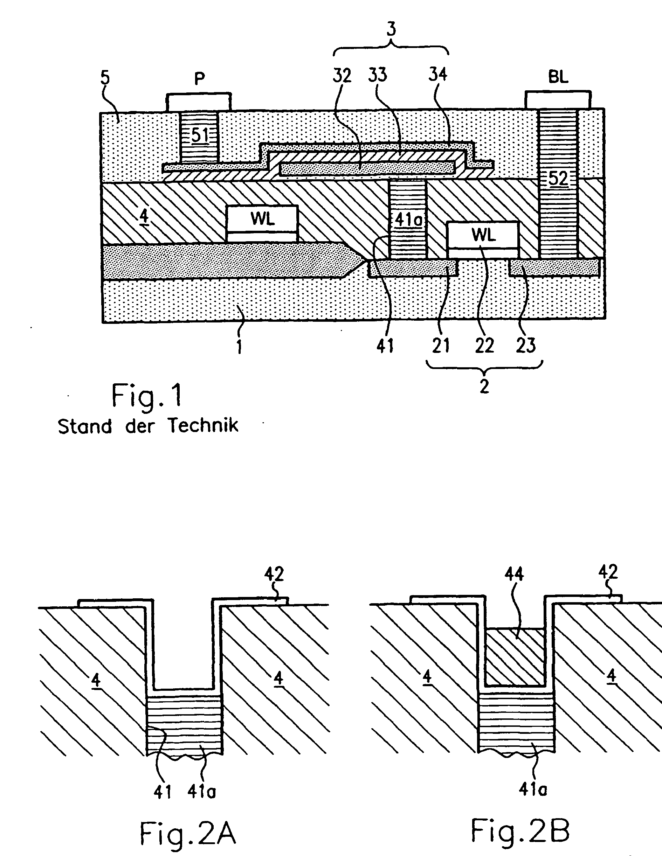

In der Fig.1 ist eine Querschnittsansicht einer konventionellen DRAM-Speicherzelle nach dem Konzept der gestapelten Zelle ("stacked cell") schematisch dargestellt. Bei diesem Aufbau der Speicherzelle sind der Schalttransistor 2 und der Speicherkondensator 3 im wesentlichen direkt übereinander angeordnet, wobei die untere Elektrode 32 des Speicherkondensators 3 mit dem Drain-Gebiet 21 des MOS-Transistors 2 durch einen mit einem Füllstopfen 41a aus elektrisch leitfähigem Material gefüllten und durch eine Isolationsschicht 4 geätzten Durchgangskontakt 41 ("plug") elektrisch miteinander verbunden ist.

Auf einem Halbleitersubstrat 1 wird zunächst ein MOS-Transistor 2 dadurch hergestellt, indem durch Dotierung ein Drain-Gebiet 21 und ein Source-Gebiet 23 gebildet werden, zwischen denen ein Kanal besteht, der durch ein über dem Kanal angeordnetes Gate 22 in seiner Leitfähigkeit gesteuert werden kann. Das Gate 22 kann durch eine Wortleitung WL des Speicherbauelements gebildet oder mit dieser verbunden sein. Das Source-Gebiet 23 ist mit einer Bitleitung BL des Speicherbauelements durch einen Durchgangskontakt 52 verbunden.

Der MOS-Transistor 2 wird anschließend mit einer planarisierenden Isolationsschicht 4, beispielsweise mit einem Oxid, wie SiO₂, bedeckt.

Auf dieser Isolationsschicht 4 wird ein Speicherkondensator 3 geformt, indem zuerst eine untere Elektrodenschicht 32 aufgebracht und strukturiert wird, welche mit dem Drain-Gebiet 21 des MOS-Transistors 2 durch den Durchgangskontakt 41 elektrisch verbunden ist. Auf die untere Elektrodenschicht 32 wird dann eine metalloxidhaltige Kondensatorzwischenschicht 33 eines ferroelektrischen Materials abgeschieden, welche das Kondensatormaterial bildet. Auf diese Schicht 33 wird eine obere Elektrodenschicht 34 ganzflächig abgeschieden und strukturiert.

Die erhaltene Struktur wird schließlich wiederum von einer zweiten planarisierenden Isolationsschicht 5, beispielsweise einer Oxidschicht, wie SiO₂, bedeckt. In diese wird ein weiterer Durchgangskontakt 51 geformt, durch den die obere Elektrode 34 des Speicherkondensators 3 mittels eines geeigneten leitfähigen Materials mit einem äußeren elektrischen Anschluß P (gemeinsame Kondensatorplatte) verbunden werden kann.

Das Source-Gebiet 23 des MOS-Transistors 2 wird dadurch mit der Bitleitung BL verbunden, indem der sich durch beide Isolationsschichten 4 und 5 erstreckende Durchgangskontakt 52 gebildet und mit einem leitfähigen Material, wie polykristallinem Silizium, gefüllt wird.

Die fortschreitende Integrationsdichte bei Speicherbauelementen hat eine entsprechende Verringerung der pro Speicherbauelement zur Verfügung stehenden Fläche zur Folge. Andererseits besteht das Erfordernis, ein ausreichend großes Lesesignal aus der Speicherzelle zu erhalten. Daher wurden im Stand der Technik weitere Bauformen des Stapelkondensators entwickelt, mit denen bei gleichbleibendem Flächenbedarf eine Steigerung der Speicherkapazität erzielt wurde.

Diese Bauelemente sind beispielsweise in dem Buch "Technologie hochintegrierter Schaltungen" von D. Widmann, H. Mader und H. Friedrich, erschienen im Springer-Verlag, 2. Aufl. (ISBN 3-540-59357-8) in dem Abschnitt 8.4.2 "Aufbau von dynamischen Speicherzellen" beschrieben und in den Abbildungen 8.4.3c und d dargestellt. Sie tragen dort die Bezeichnungen "Kronen-Stapelkondensator" und "Rauh-Silizium-Stapelkondensator". Ihr Konzept beruht im wesentlichen darauf, daß eine in vertikaler Richtung mehrfach gefaltete Kondensatorzwischenschicht gebildet wird und damit die Speicherkapazität gesteigert wird, ohne daß dies mit einer lateralen Vergrößerung des Speicherbauelements einhergeht. Der Nachteil dieses Konzepts liegt jedoch - wie man in den oben genannten Abbildungen leicht erkennen kann - in der Erhöhung der Stapelhöhe der Bauelemente.

In der Druckschrift EP-A-0 991 117 A2 wird eine Speicherzelle mit einem Auswahltransistor und einem Speicherkondensator beschrieben, bei der ein Anschlußgebiet des Schalttransistors durch einen in einer Isolationsschicht gebildeten leitfähigen Füllstopfen mit dem Speicherkondensator verbunden ist, der oberhalb des Füllstopfens in einer wannenförmigen Ausnehmung der Isolationsschicht ausgebildet ist. Zwischen die Wand der wannenförmigen Ausnehmung und der unteren Elektrodenschicht des Speicherkondensators ist eine Ti-Zwischenschicht als Diffusionsbarriere derart eingebracht, daß sie von der Oberfläche der Isolationsschicht zurückversetzt ist.

In der Druckschrift US-A-5 828 092 wird ebenfalls eine Speicherzelle mit einem Auswahltransistor und einem Speicherkondensator beschrieben, bei der der Speicherkondensator durch eine in einer Isolationsschicht gebildete Kontaktöffnung mit dem Anschlußgebiet des Auswahltransistors verbunden ist. Die Kontaktöffnung weist vertikale Seitenwände auf und der Speicherkondensator erstreckt sich von oben in die Kontaktöffnung hinein bis zu einem unteren Füllstopfen.

Der vorliegenden Erfindung liegt somit die Aufgabe zugrunde, einen Speicherkondensator, insbesondere einen ferroelektrischen oder paraelektrischen Speicherkondensator mit zugehöriger Kontaktierungsstruktur anzugeben, welcher eine erhöhte Speicherkapazität bei gleichbleibenden lateralen und vertikalen Strukturdimensionen aufweist. Eine weitere Aufgabe der Erfindung besteht in der Angabe eines Verfahren zur Herstellung eines derartigen Speicherkondensators mit Kontaktierungsstruktur.

Diese Aufgabe wird durch die Merkmale der unabhängigen Patentansprüche gelöst. Vorteilhafte Weiterbildungen und Ausgestaltungen sind in den Unteransprüchen angegeben.

Die Erfindung beruht im wesentlichen auf dem Gedanken, den Speicherkondensator so zu formen, daß sich ein Abschnitt davon in den Durchgangskontakt hinein erstreckt, mit welchem der Speicherkondensator elektrisch kontaktiert ist. Dieser Durchgangskontakt ist in einer Isolationsschicht geformt, auf deren einer Seite der Speicherkondensator angeordnet ist. Der Durchgangskontakt kann beispielsweise mit einem auf der anderen Seite der Isolationsschicht angeordneten Schalttransistor verbunden sein.

Die Erfindung schafft somit eine dreidimensionale Erweiterung des Speicherkondensators, ohne daß dabei jedoch die Stapelhöhe des Bauelements vergrößert werden muß. Der Speicherkondensator dehnt sich vielmehr in einen Bereich aus, der ohnehin in dem Bauelement platzmäßig bereitgestellt werden muß. Es muß somit kein zusätzlicher Platz für die dreidimensionale Ausdehnung des Speicherkondensators bereitgestellt werden.

Bei der Erfindung wird ein Speicherkondensator derart geformt, daß er sich ausgehend von der Ebene der Oberfläche der Isolationsschicht mindestens teilweise in das Innere des Durchgangskontakts erstreckt und mit dem Durchgangskontakt elektrisch verbunden ist.

In einer einfachen Ausführungsform ist der Speicherkondensator in dem sich in das Innere des Durchgangskontakts erstrekkenden Abschnitt einfach gefaltet, d.h. er weist eine Struktur mit zwei zu dem Durchgangskontakt parallelen Abschnitten und einen diese an ihren Enden verbindenden Abschnitt auf. Es ist jedoch ebenso möglich, daß der Speicherkondensator in diesem Abschnitt mehrfach gefaltet ist, wobei die beschriebene einfach gefaltete Struktur mehrfach aneinandergefügt ist.

Der Speicherkondensator weist vorzugsweise in an sich üblicher Weise eine erste Elektrodenschicht, eine zweite Elektrodenschicht und eine dielektrische, ferroelektrische oder paraelektrische Kondensatorzwischenschicht auf und normalerweise ist eine der beiden Elektrodenschichten, beispielsweise die erste Elektrodenschicht in dem gefalteten Abschnitt dem Inneren des Durchgangskontakts zugewandt und mit dem Durchgangskontakt, bzw. mit in dem Durchgangskontakt vorhandenen elektrisch leitenden Material elektrisch verbunden.

In dem gefalteten Kondensatorabschnitt können die erste Elektrodenschicht und die Kondensatorzwischenschicht jeweils zwei im wesentlichen parallele, entlang dem Durchgangskontakt verlaufende Abschnitte und einen diese Abschnitte an ihren Enden verbindenden Abschnitt aufweisen. Die zweite Elektrodenschicht kann dann so beschaffen sein, daß sie in dem gefalteten Kondensatorabschnitt lediglich die Lücke zwischen den beiden vertikalen Abschnitten der Kondensatorzwischenschicht ausfüllt.

Vorzugsweise ist der Speicherkondensator so geformt, daß er außer dem sich in das Innere des Durchgangskontakts erstrekkenden, gefalteten Abschnitt noch einen oder mehrere, auf der Oberfläche der Isolationsschicht planar angeordnete Abschnitte aufweist.

Bezüglich der Kontaktierung des Speicherkondensators innerhalb des Durchgangskontakts ist vorzugsweise die erste Elektrodenschicht an allen drei Abschnitten mit elektrisch leitfähigem Material des Durchgangskontakts verbunden. Im Prinzip genügt es jedoch, wenn sie an mindestens einem ihrer Abschnitte entsprechend elektrisch kontaktiert ist.

Der Durchgangskontakt kann so beschaffen sein, daß er einen von der Ebene der Oberfläche der Isolationsschicht zurückversetzten Füllstopfen aus elektrisch leitfähigem Material, beispielsweise dotiertem polykristallinem Silizium, enthält. Auf diesem können gewünschtenfalls weitere elektrisch leitfähige Kontaktschichten aufgebracht sein. Auf diesen Schichten oder direkt auf dem Füllstopfen kann der horizontale Abschnitt des Speicherkondensators aufliegen.

Es können jedoch auch auf dem zurückversetzten Füllstopfen eine oder mehrere elektrisch leitfähige Kontaktschichten so abgeschieden oder strukturiert werden, daß sie eine kastenförmige Struktur mit zwei parallelen, entlang der Richtung des Durchgangskontakts verlaufenden Abschnitten und einen diese verbindenden Abschnitt aufweisen. Mit diesen Abschnitten kann die erste Elektrodenschicht des Speicherkondensators umfaßt werden, wodurch ein optimaler elektrischer Kontakt hergestellt wird.

Eine derartige Struktur kann auch mit einem einzigen elektrisch leitfähigen Material hergestellt werden. Dabei wird die in der Isolationsschicht geformte Durchgangsöffnung derart mit mindestens einem leitfähigen Material, etwa polykristallinem Silizium befüllt, daß ein von leitfähigem Material freier und nach außen offener Leerraum verbleibt und anschließend wird ein Speicherkondensator mindestens teilweise in diesen Leerraum abgeschieden.

Der Leerraum kann am einfachsten dadurch hergestellt werden, daß die Durchgangsöffnung nicht ganz mit dem elektrisch leitfähigem Material aufgefüllt wird und der Leerraum durch den nicht befüllten Abschnitt der Durchgangsöffnung gebildet wird. Es kann auch die Durchgangsöffnung vollständig mit dem leitfähigen Material aufgefüllt werden und anschließend kann der Leerraum dadurch erzeugt werden, indem beispielsweise durch einen Ätzschritt eine Ausnehmung vorgegebener Tiefe in das leitfähige Material geformt wird. Dabei kann das Material in der gesamten Breite des Durchgangskontakts vollständig bis zu der vorgegebenen Tiefe entfernt werden. Es können aber auch gegenüberstehende Seitenwände stehenbleiben, so daß eine kastenförmige Struktur resultiert, wie sie weiter oben bereits beschrieben wurde, durch die der Speicherkondensator geeignet umfaßt werden kann.

Die Durchgangsöffnung kann auch mit einem ersten leitfähigen Material nicht ganz aufgefüllt werden und anschließend kann in den verbleibenden Abschnitt der Durchgangsöffnung ein zweites leitfähiges Material eingefüllt werden und anschließend kann in dem zweiten leitfähigen Material die Ausnehmung wie beschrieben geformt werden.

Gewünschtenfalls kann vor dem Einfüllen des zweiten leitfähigen Materials eine Zwischenschicht eines dritten leitfähigen Materials auf der Oberfläche des ersten leitfähigen Materials gebildet werden. Eine derartige Struktur eignet sich besonders bei ferroelektrischen Speicherkondensatoren, bei denen die Zwischenschicht durch eine Ti- und/oder TiN-Schicht gebildet wird und das zweite leitfähige Material eine Sauerstoffbarrierenschicht, beispielsweise aus Ir oder IrO bildet. Diese zuletzt genannte Schicht soll verhindern, daß während der Herstellung des Kondensators bei einer thermischen Oxidation oder dergleichen Sauerstoff bis zu dem polykristallinen Silizium des Durchgangskontakts vordringt und an der Oberfläche eine elektrisch isolierende SiO₂-Schicht bildet. Iridium (Ir) oder Iridiumoxid (IrO) hat dabei den Vorteil, daß es Sauerstoff absorbieren kann, ohne seine elektrische Leitfähigkeit nennenswert einzubüßen. Die darunterliegende Ti-Zwischenschicht dient als geeignete Übergangsschicht, da sie einerseits mit dem polykristallinen Silizium eine niederohmige Titansilizid-Grenzschicht bildet und andererseits eine geeignete Nukleationsschicht für die Ir-Schicht darstellt. Diese Schichten können im Prinzip auch aus anderen Materialien gebildet sein, müssen jedoch in jedem Fall elektrisch leitfähig sein.

Erfindungsgemäß wird bei der soeben beschriebenen Verwendung einer Sauerstoffbarrierenschicht und einer geeigneten Zwischenschicht die Barrierenschicht derart auf der Zwischenschicht abgeschieden, daß die Zwischenschicht vollständig von dem darunterliegenden Füllstopfen, der seitlich davon befindlichen Isolationsschicht und der Barrierenschicht umgeben ist. Dadurch wird wirksam verhindert, daß die zumeist aus Titan geformte Zwischenschicht bei einem thermischen Oxidationsschritt wie er beim Konditionieren der ferroelektrischen Schicht durchgeführt wird, an ihrer Oberfläche eine dünne Oxidschicht bildet.

Der erfindungsgemäße Speicherkondensator mit der dazugehörigen Kontaktierungsstruktur können Bestandteil eines Speicherbauelements sein, bei welchem auf einem Substrat wie einem Halbleitersubstrat ein Schalttransistor geformt ist, auf dem Schalttransistor eine Isolationsschicht aufgebracht ist und in und auf die Isolationsschicht die Kontaktierungsstruktur und der Speicherkondensator gebildet sind.

Im folgenden wird ein einziges Ausführungsbeispiel der Erfindung anhand eines ferroelektrischen Speicherkondensators im Zusammenhang mit den Zeichnungen näher erläutert. Es zeigen:
- Fig.1: eine Querschnittsansicht einer konventionellen DRAM-Speicherzelle mit einem ferroelektrischen Stapelkondensator;
- Fig.2A-H: ein Ausführungsbeispiel für die erfindungsgemäße Herstellung des Speicherkondensators mit Kontaktierungsstruktur.

Das im folgenden beschriebene Ausführungsbeispiel betrifft einen Speicherkondensator mit ferroelektrischer Kondensatorzwischenschicht. Die Erfindung ist jedoch ebenso auf Speicherkondensatoren mit konventionellen Dielektrika anwendbar.

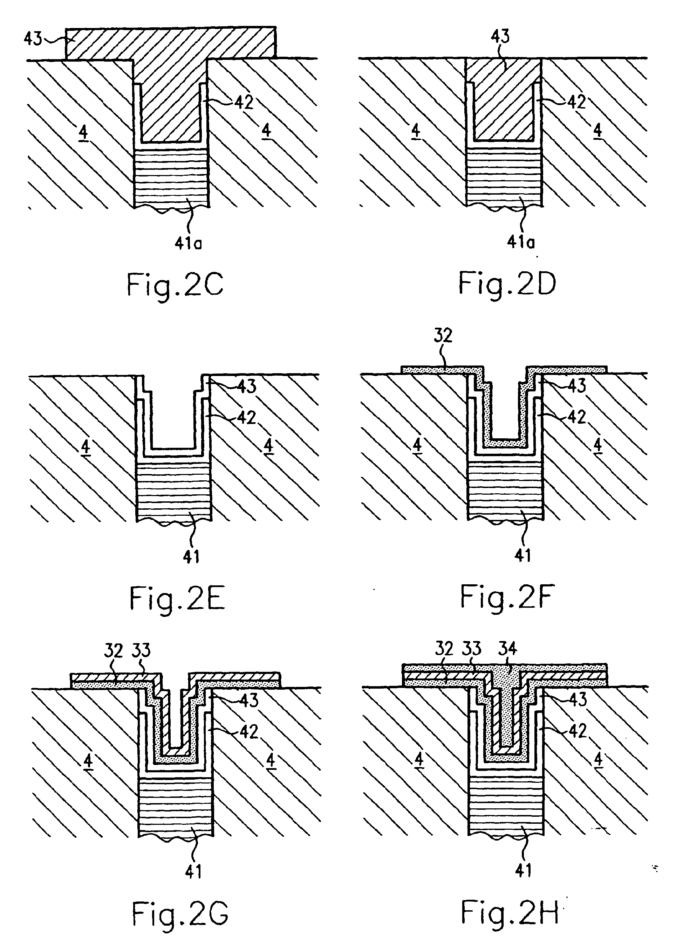

In der Fig.2A ist ein oberer Abschnitt des in die Isolationsschicht 4 geformten Durchgangskontakts 41 im Querschnitt dargestellt. Unterhalb der Isolationsschicht 4 kann sich beispielsweise ein bereits fertiggestellter Schalttransistor befinden, dessen Drain- oder Source-Anschluß mit dem Durchgangskontakt verbunden ist.

Der Durchgangskontakt ist bis zu einer bestimmten Höhe mit einem Füllstopfen 41a aus dotiertem polykristallinem Silizium gefüllt. Diese Struktur wird meistens so hergestellt, daß der Durchgangskontakt 41 zunächst vollständig mit Poly-Silizium aufgefüllt und anschließend zum Teil durch einen Ätzschritt wieder entfernt wird. Dann wird eine Zwischenschicht aus einer Ti-, TiN- oder Ti/TiN-Doppelschicht 42 abgeschieden, so daß diese zwei gegenüberstehende Innenwände des Durchgangskontakts 41 in diesem oberen Abschnitt bedeckt und einen Randabschnitt beidseits des Durchgangskontakts 41 auf der oberen Oberfläche der Isolationsschicht 4 bedeckt. Die Zwischenschicht 42 bildet somit eine gleichsam kastenförmige Struktur, bei der jedoch die zu der Bildebene parallel liegenden Innenwände der Durchgangsöffnung nicht mit der Zwischenschicht 42 versehen sind.

Gemäß Fig.2B wird dann der Durchgangskontakt 41 bis zu einer bestimmten Höhe mit einer Photoresistschicht 44 gefüllt. Diese Photoresistschicht 44 dient als Maskierungsschicht für einen nachfolgenden Ätzschritt zur selektiven Entfernung der Zwischenschicht 42. In diesem Ätzschritt werden dann die von der Photoresistschicht 44 unbedeckten Abschnitte der Zwischenschicht 42 entfernt.

Nach der Entfernung dieser Abschnitte der Zwischenschicht 42 wird dann gemäß Fig.2C eine Sauerstoffbarrierenschicht 43, beispielsweise aus Ir oder IrO in die Durchgangsöffnung und auf einen Oberflächenabschnitt der Isolationsschicht 4 abgeschieden. Dieser auf der Oberfläche der Isolationsschicht 4 überstehende Teil der Barrierenschicht 43 kann dann durch einen CMP-Prozeß entfernt werden, so daß die in Fig.2D gezeigte Struktur resultiert.

Die Zwischenschicht 42 reicht somit nicht bis an die Oberfläche der Struktur heran, sondern ist um einen geringen Abstand in die Tiefe der Struktur zurückversetzt. Dieser Abstand wird durch die Höhe der gemäß Fig.2B abgeschiedenen Photoresistschicht 44 bestimmt. Durch diesen Abstand wird wirksam verhindert, daß Sauerstoffatome, die beispielsweise bei einem Temperprozeß an der ferroelektrischen Schicht in tiefere Regionen der Struktur diffundieren, in die Zwischenschicht 42 eindringen und an ihrer Oberfläche eine elektrisch isolierende Oxidschicht bilden.

Gemäß Fig.2E wird dann ein gegebenenfalls zweistufiger anisotroper Ätzprozess an der Barrierenschicht 43 durchgeführt, bei dem das Material der Barrierenschicht 43 bis auf eine kastenförmige Struktur entfernt wird, welche der kastenförmigen Struktur der Zwischenschicht 42 entspricht. Somit ist eine Kontaktierungsstruktur geschaffen, in die der Speicherkondensator abgeschieden werden kann.

Gemäß Fig.2F wird eine erste Elektrodenschicht 32 des Speicherkondensators 3 abgeschieden, die beispielsweise aus Platin bestehen kann. Sie wird so in die Durchgangsöffnung abgeschieden, daß sie wie die sie umgebenden Schichten 42 und 43 eine kastenförmige Struktur mit zwei vertikalen gegenüberstehenden Abschnitten und einem diese am Boden verbindenden horizontalen Abschnitt aufweist.

In ebensolcher Weise wird dann eine ferroelektrische Kondensatorzwischenschicht auf die erste Elektrodenschicht 32 aufgebracht. Diese ferroelektrische Schicht kann unmittelbar nach ihrem Aufbringen thermisch behandelt "(konditioniert") werden. Gegebenenfalls kann dieser Prozeßschritt aber auch zu einem späteren Zeitpunkt während des Herstellungsprozesses des Bauelements durchgeführt werden.

In einem letzten Herstellungsschritt des Speicherkondensators wird dann gemäß Fig.2F die zweite Elektrodenschicht 34 auf die Kondensatorzwischenschicht 33 aufgebracht. Die zweite Elektrodenschicht 34 wird vorzugsweise aus demselben Material wie die erste Elektrodenschicht 32 gefertigt, so daß sie also in dem gewählten Beispiel aus Platin besteht. Sie kann relativ einfach derart abgeschieden werden, daß sie auf den horizontalen Abschnitten die Kondensatorzwischenschicht 33 bedeckt und in dem vertikalen Abschnitt den Zwischenraum zwischen den vertikalen Abschnitten der Kondensatorzwischenschicht 33 ausfüllt.

Somit ist ein Speicherkondensator fertiggestellt, der durch Ausnutzung eines Raumbereichs des Durchgangskontakts eine vergrößerte Speicherkapazität aufweist, ohne daß hierfür eine Erhöhung der Stapelhöhe in Kauf genommen werden muß.

## Patentansprüche

1. Speicherkondensator, insbesondere ferroelektrischer oder paraelektrischer Speicherkondensator, und dazugehörige Kontaktierungsstruktur, bei welchen
- die Kontaktierungsstruktur in einer in einer Isolationsschicht (4) geformten Kontaktöffnung (41) gebildet ist, die einen von der Oberfläche der Isolationsschicht (4) zurückversetzten Füllstopfen (41a) aus elektrisch leitfähigem Material enthält,
- der Speicherkondensator (3) eine erste Elektrodenschicht (32), eine zweite Elektrodenschicht (34) und eine dielektrische, ferroelektrische oder paraelektrische Kondensatorzwischenschicht (33) aufweist, und
- sich ausgehend von der Ebene der Oberfläche der Isolationsschicht (4) mindestens teilweise in das Innere der Kontaktöffnung (41) erstreckt,
**dadurch gekennzeichnet, daß**
- in der Kontaktöffnung (41) oberhalb des Füllstopfens (41a) eine leitfähige, oxidierbare Zwischenschicht (42) in Form eines horizontalen Schichtabschnitts auf der horizontalen Oberfläche des Füllstopfens (41a) und daran angrenzend in Form von vertikalen Schichtabschnitten entlang den Seitenwänden der Kontaktöffnung (41) bis zu einer Höhe unterhalb der Oberfläche der Isolationsschicht (4) ausgebildet ist, und
- auf den Schichtabschnitten der Zwischenschicht (42) und dem oberhalb davon gelegenen vertikalen Abschnitt der Isolationsschicht (4) eine leitfähige Sauerstoffbarrierenschicht (43) bis zu der Oberfläche der Isolationsschicht (4) ausgebildet ist, so daß die Zwischenschicht (42) vollständig von dem Füllstopfen (41a), der Isolationsschicht (4) und der Barrierenschicht (43) umgeben ist, und der Speicherkondensator (3) innerhalb der Kontaktöffnung (41) mit der Sauerstoffbarrierenschicht (43) verbunden ist.

2. Speicherkondensator und Kontaktierungsstruktur nach Anspruch 1
**dadurch gekennzeichnet, daß**
- die Zwischenschicht (42) eine Ti-Schicht, eine TiN-Schicht oder eine Ti/TiN-Doppelschicht enthält.

3. Speicherkondensator und Kontaktierungsstruktur nach Anspruch 1 oder 2,
**dadurch gekennzeichnet, daß**
- die Barrierenschicht (43) eine Ir-Schicht oder eine IrO-Schicht enthält.

4. Speicherkondensator und Kontaktierungsstruktur nach einem der vorhergehenden Ansprüche,
**dadurch gekennzeichnet, daß**
- das leitfähige Material des Füllstopfens (41a) polykristallines Silizium ist.

5. Speicherkondensator und Kontaktierungsstruktur nach einem der vorhergehenden Ansprüche,
**dadurch gekennzeichnet, daß**
- die zweite Elektrodenschicht (34) einen entlang der Kontaktöffnung (41) verlaufenden, die Lücke zwischen den parallelen, vertikalen Abschnitten der Kondensatorzwischenschicht (33) ausfüllenden Abschnitt aufweist.

6. Speicherbauelement, mit
- einem auf einem Substrat (1) geformten Schalttransistor (2),
- einer auf dem Schalttransistor (2) aufgebrachten Isolationsschicht (4), und
- einem Speicherkondensator (3) und einer Kontaktierungsstruktur, welche gemäß einem der vorhergehenden Ansprüche in und auf der Isolationsschicht (4) gebildet sind.

7. Verfahren zur Herstellung eines Speicherkondensators, insbesondere eines ferroelektrischen oder paraelektrischen Speicherkondensators und einer Kontaktierungsstruktur für die Kontaktierung des Speicherkondensators mit einem Schalttransistor (2) durch eine Isolationsschicht (4), bei welchem
a) in die Isolationsschicht (4) eine Kontaktöffnung (41) geformt wird,
b) die Kontaktöffnung (41) bis zu einer von der Oberfläche der Isolationsschicht (4) zurückversetzten Höhe mit einem Füllstopfen (41) aus elektrisch leitfähigem Material befüllt wird,
c) in der Kontaktöffnung (41) oberhalb des Füllstopfens (41a) eine leitfähige, oxidierbare Zwischenschicht (42) in Form eines horizontalen Schichtabschnitts auf der horizontalen Oberfläche des Füllstopfens (41a) und daran angrenzend in Form von vertikalen Schichtabschnitten entlang den Seitenwänden der Kontaktöffnung (41) bis zu einer Höhe unterhalb der Oberfläche der Isolationsschicht (4) abgeschieden wird,
d) auf den Schichtabschnitten der Zwischenschicht (42) und dem oberhalb davon gelegenen vertikalen Abschnitt der Isolationsschicht (4) eine leitfähige Sauerstoffbarrierenschicht (43) bis zu der Oberfläche der Isolationsschicht (4) abgeschieden wird, so daß die Zwischenschicht (42) vollständig von dem Füllstopfen (41a), der Isolationsschicht (4) und der Barrierenschicht (43) umgeben ist, und
e) ein Speicherkondensator abgeschieden wird, der sich teilweise in die Kontaktöffnung (41) hinein erstreckt und innerhalb der Kontaktöffnung (41) mit der Sauerstoffbarrierenschicht (34) kontaktiert wird.

8. Verfahren nach Anspruch 7,
**dadurch gekennzeichnet, daß**
- im Verfahrensschritt c) zunächst die Zwischenschicht (42) derart abgeschieden wird, daß sie die Innenwand des oberen, nicht gefüllten Abschnitts der Kontaktöffnung (41) bis auf einen oberen umlaufenden Randabschnitt bedeckt, und anschließend
- in die Kontaktöffnung (41) die Barrierenschicht (43) abgeschieden wird.

9. Verfahren nach Anspruch 8,
**dadurch gekennzeichnet, daß**
- im Verfahrensschritt c) die Zwischenschicht (42) zunächst so abgeschieden wird, daß sie die Innenwand vollständig bedeckt,
- dann eine Photoresistschicht (44) bis zu der Höhe der unteren Kante des Randabschnitts in die Kontaktöffnung (41) gefüllt wird,
- der nicht von der Photoresistschicht (44) bedeckte Abschnitt der Zwischenschicht (42) durch einen Ätzschritt entfernt wird, und anschließend
- die Photoresistschicht (44) entfernt wird.

10. Verfahren nach einem der Ansprüche 6 bis 8,
**dadurch gekennzeichnet, daß**
- die Zwischenschicht (42) eine Ti-Schicht, eine TiN-Schicht oder eine Ti/TiN-Doppelschicht enthält.

11. Verfahren nach einem der Ansprüche 7 bis 10,
**dadurch gekennzeichnet, daß**
- die Barrierenschicht (43) eine Ir-Schicht oder eine IrO-Schicht enthält.

12. Verfahren nach einem der Ansprüche 7 bis 11,
**dadurch gekennzeichnet, daß**
- das leitfähige Material in der Kontaktöffnung (41) polykristallines Silizium ist.

13. Herstellungsverfahren für ein Speicherbauelement, bei welchem
- auf einem Substrat (1) ein Schalttransistor (2) geformt wird,
- auf dem Schalttransistor (2) eine Isolationsschicht (4) aufgebracht wird,
- in der Isolationsschicht (4) eine Kontaktierungsstruktur nach einem der Ansprüche 7 bis 12 gebildet wird, und auf der Kontaktierungsstruktur ein ferro- oder paraelektrischer Speicherkondensator (3) geformt wird.
- in der Isolationsschicht (4) eine Kontaktierungsstruktur nach einem der Ansprüche 7 bis 12 gebildet wird, und auf der Kontaktierungsstruktur ein ferro- oder paraelektrischer Speicherkondensator (3) geformt wird.

## Claims

1. Storage capacitor, in particular ferroelectric or paraelectric storage capacitor, and associated contact-making structure, in which
- the contact-making structure is formed in a contact opening (41) formed in an insulation layer (4), which contact opening contains a filling plug (41a) made of electrically conductive material set back from the surface of the insulation layer (4),
- the storage capacitor (3) has a first electrode layer (32), a second electrode layer (34) and a dielectric, ferroelectric or paraelectric capacitor intermediate layer (33), and,
- proceeding from the plane of the surface of the insulation layer (4), extends at least partly into the interior of the contact opening (41),
**characterized in that**
- in the contact opening (41) above the filling plug (41a), a conductive, oxidizable intermediate layer (42) is formed in the form of a horizontal layer section on the horizontal surface of the filling plug (41a) and, adjoining that, in the form of vertical layer sections along the sidewalls of the contact opening (41) up to a height below the surface of the insulation layer (4), and
- on the layer sections of the intermediate layer (42) and the vertical section of the insulation layer (4) located above the latter, a conductive oxygen barrier layer (43) is formed up to the surface of the insulation layer (4), so that the intermediate layer (42) is completely surrounded by the filling plug (41a), the insulation layer (4) and the barrier layer (43), and the storage capacitor (3) is connected to the oxygen barrier layer (43) within the contact opening (41).

2. Storage capacitor and contact-making structure according to Claim 1,
**characterized in that**
- the intermediate layer (42) contains a Ti layer, a TiN layer or a Tin/TiN double layer.

3. Storage capacitor and contact-making structure according to Claim 1 or 2,
**characterized in that**
- the barrier layer (43) contains an Ir layer or an IrO layer.

4. Storage capacitor and contact-making structure according to one of the preceding claims,
**characterized in that**
- the conductive material of the filling plug (41a) is polycrystalline silicon.

5. Storage capacitor and contact-making structure according to one of the preceding claims,
**characterized in that**
- the second electrode layer (34) has a section which runs along the contact opening (41) and fills the gap between the parallel, vertical sections of the capacitor intermediate layer (33).

6. Memory component, having
- a switching transistor (2) formed on a substrate (1),
- an insulation layer (4) applied on the switching transistor (2), and
- a storage capacitor (3) and a contact-making structure, which are formed in and on the insulation layer (4) in accordance with one of the preceding claims.

7. Method for fabricating a storage capacitor, in particular a ferroelectric or paraelectric storage capacitor, and a contact-making structure for the contact-connection of the storage capacitor to a switching transistor (2) through an insulation layer (4), in which
a) a contact opening (41) is formed in the insulation layer (4),
b) the contact opening (41) is filled with a filling plug (41) made of electrically conductive material up to a height that is set back from the surface of the insulation layer (4),
c) in the contact opening (41) above the filling plug (41a), a conductive, oxidizable intermediate layer (42) is deposited in the form of a horizontal layer section on the horizontal surface of the filling plug (41a) and, adjoining that, in the form of vertical layer sections along the sidewalls of the contact opening (41) up to a height below the surface of the insulation layer (4),
d) on the layer sections of the intermediate layer (42) and the vertical section of the insulation layer (4) located above the latter, a conductive oxygen barrier layer (43) is deposited up to the surface of the insulation layer (4), so that the intermediate layer (42) is completely surrounded by the filling plug (41a), the insulation layer (4) and the barrier layer (43), and
e) a storage capacitor is deposited, which partly extends into the contact opening (41) and is contact-connected to the oxygen barrier layer (34) within the contact opening (41).

8. Method according to Claim 7,
**characterized in that**
- in method step c), firstly the intermediate layer (42) is deposited in such a way that it covers the inner wall of the upper, non-filled section of the contact opening (41) apart from an upper peripheral edge section, and afterwards
- the barrier layer (43) is deposited into the contact opening (41).

9. Method according to Claim 8,
**characterized in that**
- in method step c), the intermediate layer (42) is firstly deposited in such way that it completely covers the inner wall,
- then a photoresist layer (44) is filled into the contact opening (41) up to the height of the lower edge of the edge section,
- the section of the intermediate layer (42) which is not covered by the photoresist layer (44) is removed by means of an etching step, and afterwards
- the photoresist layer (44) is removed.

10. Method according to one of Claims 6 to 8,
**characterized in that**
- the intermediate layer (42) contains a Ti layer, a TiN layer or a Ti/TiN double layer.

11. Method according to one of Claims 7 to 10,
**characterized in that**
- the barrier layer (43) contains an Ir layer or an IrO layer.

12. Method according to one of Claims 7 to 11,
**characterized in that**
- the conductive material in the contact opening (41) is polycrystalline silicon.

13. Method for fabricating a memory component, in which
- a switching transistor (2) is formed on a substrate (1),
- an insulation layer (4) is applied on the switching transistor (2),
- a contact-making structure according to one of Claims 7 to 12 is formed in the insulation layer (4), and a ferroelectric or paraelectric storage capacitor (3) is formed on the contact-making structure.

## Revendications

1. Condensateur d'emmagasinage, notamment condensateur d'emmagasinage ferroélectrique ou paraélectrique, et structure de mise en contact en faisant partie, dans lesquels
- la structure de mise en contact est formée dans une ouverture (41) de contact qui est ménagée dans une couche (4) isolante et qui comporte un bouchon (41a) de remplissage en une matière conductrice de l'électricité en retrait de la surface de la couche (4) isolante ;
- le condensateur (3) d'emmagasinage a une première couche (32) d'électrode, une deuxième couche (34) d'électrode et une couche (33) intermédiaire de condensateur diélectrique, ferroélectrique ou paraélectrique ; et
- en partant du plan de la surface de la couche (4) isolante, s'étend au moins en partie à l'intérieur de l'ouverture (41) de contact,
**caractérisé en ce que**
- il est constitué dans l'ouverture (41) de contact, au-dessus du bouchon (41a) de remplissage, une couche (42) intermédiaire, conductrice et oxydable, sous la forme d'une partie horizontale de couche sur la surface horizontale du bouchon (41a) de remplissage et en en étant voisine sous la forme de tronçons verticaux de couche le long des parois latérales de l'ouverture (41) de contact jusqu'à un niveau en dessous de la surface de la couche (4) isolante ; et
- sur les tronçons de la couche (42) intermédiaire et le tronçon vertical, mis au-dessus de cette couche, de la couche (4) isolante, il est constitué une couche (43) conductrice formant barrière à l'oxygène jusqu'à la surface de la couche (4) isolante, de sorte que la couche (42) intermédiaire est entourée entièrement du bouchon (41a) de remplissage de la couche (4) isolante et de la couche (43) barrière et le condensateur (3) d'emmagasinage est relié à l'intérieur de l'ouverture (41) de contact à la couche (43) formant barrière à l'oxygène.

2. Condensateur d'emmagasinage et structure de mise en contact suivant la revendication 1,
**caractérisé en ce que**
- la couche (42) intermédiaire comporte une couche de Ti, une couche de TiN ou une couche double de Ti/TiN.

3. Condensateur d'emmagasinage et structure de mise en contact suivant la revendication 1 ou 2,
**caractérisé en ce que**
- la couche (43) formant barrière comporte une couche de Ir ou une couche de IrO.

4. Condensateur d'emmagasinage et structure de mise en contact suivant l'une des revendications précédentes,
**caractérisé en ce que**
- la matière conductrice du bouchon (41a) de remplissage est du silicium polycristallin.

5. Condensateur d'emmagasinage et structure de mise en contact suivant l'une des revendications précédentes,
**caractérisé en ce que**
- la deuxième couche (34) d'électrode a une partie qui s'étend le long de l'ouverture (41) de contact et qui remplit les intervalles entre les parties parallèles verticales de la couche (33) intermédiaire du condensateur.

6. Composant de mémoire comprenant
- un transistor (2) de commutation formé sur un substrat (1) ;
- une couche (4) isolante déposée sur le transistor (2) de commutation ; et
- un condensateur (3) d'emmagasinage et une structure de mise en contact, qui sont formés suivant l'une des revendications précédentes et sur la couche (4) isolante.

7. Procédé de production d'un condensateur d'emmagasinage, notamment d'un condensateur d'emmagasinage ferroélectrique ou paraélectrique et d'une structure de mise en contact pour la mise en contact du condensateur d'emmagasinage avec un transistor (2) de commutation à travers une couche (4) isolante, dans lequel
a) on forme une ouverture (41) de contact dans la couche (4) isolante ;
b) on remplit l'ouverture (41) de contact jusqu'à un niveau en retrait de la surface de la couche (4) isolante d'un bouchon (41a) de remplissage en une matière conductrice de l'électricité ;
c) on dépose dans l'ouverture (41) de contact, au-dessus du bouchon (41a) de remplissage, une couche (42) intermédiaire, conductrice et oxydable, sous la forme d'une partie horizontale de couche sur la surface horizontale du bouchon (41a) de remplissage et en en étant voisine sous la forme de tronçons verticaux de couche le long des parois latérales de l'ouverture (41) de contact jusqu'à un niveau en dessous de la surface de la couche (4) isolante ;
d) on dépose sur les parties de la couche (42) intermédiaire et sur la partie verticale, disposée au-dessus de celle-ci, de la couche (4) isolante une couche (43) conductrice et formant barrière à l'oxygène jusqu'à la surface de la couche (4) isolante, de sorte que la couche (42) intermédiaire est entourée complètement du bouchon (41a) de remplissage de la couche (4) isolante et de la couche (43) formant barrière ; et
e) on dépose dans un condensateur d'emmagasinage qui s'étend en partie dans l'ouverture (41) de contact et qui est mis en contact à l'intérieur de l'ouverture (41) de contact avec la couche (34) formant barrière à l'oxygène.

8. Procédé suivant la revendication 7,
**caractérisé en ce que**
- dans le stade c) du procédé, on dépose d'abord la couche (42) intermédiaire de manière à ce qu'elle recouvre la paroi intérieure de la partie supérieure non remplie de l'ouverture (41) de contact à l'exception d'une partie marginale supérieure faisant le tour, et ensuite
- on dépose la couche (43) formant barrière dans l'ouverture (41) de contact.

9. Procédé suivant la revendication 8,
**caractérisé en ce que**
- au stade c) du procédé, on dépose d'abord la couche (42) intermédiaire de façon à ce qu'elle recouvre complètement la paroi intérieure ;
- puis on emplit l'ouverture (41) de contact d'une couche (44) de photorésist jusqu'au niveau de l'arête intérieure de la partie de bord ;
- on élimine par un stade d'attaque la partie de la couche (42) intermédiaire, qui n'est pas revêtue de la couche (44) de photorésist ; et ensuite
- on élimine la couche (44) de photorésist.

10. Procédé suivant l'une des revendications 6 à 8,
**caractérisé en ce que**
- la couche (42) intermédiaire comporte une couche de Ti, une couche de TiN ou une couche double de Ti/TiN.

11. Procédé suivant l'une des revendications 7 à 10,
**caractérisé en ce que**
- la couche (43) formant barrière comporte une couche de Ir ou une couche de IrO.

12. Procédé suivant l'une des revendications 7 à 11,
**caractérisé en ce que**
- la matière conductrice dans l'ouverture (41) de contact est du silicium polycristallin.

13. Procédé de production d'un composant de mémoire, dans lequel
- on forme sur un substrat (1) un transistor (2) de commutation ;
- on dépose sur le transistor (2) de commutation une couche (4) isolante ; et
- on forme dans la couche (4) isolante une structure de mise en contact suivant l'une des revendications 7 à 12 et on forme sur la structure de mise en contact un condensateur (3) d'emmagasinage ferroélectrique ou paraélectrique.
